Europäisches Patentamt

European Patent Office

Office européen des brevets

(19)

(11) Publication number : **0 557 094 A1**

# (12) EUROPEAN PATENT APPLICATION

(21) Application number : 93301197.5

(22) Date of filing : 18.02.93

(51) Int. Cl.⁵ : **G11B 5/09, G11B 5/02**

(30) Priority : **19.02.92 JP 69865/92**
**05.02.93 JP 40727/93**

(43) Date of publication of application :
**25.08.93 Bulletin 93/34**

(84) Designated Contracting States :
**DE FR GB IT NL**

(71) Applicant : **CANON KABUSHIKI KAISHA**
**30-2, 3-chome, Shimomaruko, Ohta-ku**
**Tokyo (JP)**

(72) Inventor : **Hasegawa, Koyo, c/o Canon**
**Kabushiki Kaisha**
**30-2, 3-chome, Shimomaruko, Ohta-ku**
**Tokyo (JP)**
Inventor : **Ishii, Kazuyoshi, c/o Canon**
**Kabushiki Kaisha**
**30-2, 3-chome, Shimomaruko, Ohta-ku**
**Tokyo (JP)**

(74) Representative : **Beresford, Keith Denis Lewis**
**et al**
**BERESFORD & Co. 2-5 Warwick Court High**
**Holborn**
**London WC1R 5DJ (GB)**

(54) **Magnetic head drive device.**

(57)   A magnetic head device to be used in a magnetic recording apparatus is provided with a magnetic head constructed by a main coil, a power source, first and second auxiliary coils, first and second switching elements and a drive signal generating circuit. The power source applies a current to the main coil. The first and second auxiliary coils are respectively connected to both sides of the main coil between the power source and the main coil. The first and second switching elements are respectively serially connected to the first and second auxiliary coils. The first and second switching elements are adapted to be alternately turned on/off on the basis of an information signal, in which the direction of the current flowing in the main coil is switched in correspondence to the on/off operations of the first and second switching elements. The drive signal generating circuit supplies the current to the first and second auxiliary coils prior to recording of information.

FIG. 6

## BACKGROUND OF THE INVENTION

### Field of the Invention

The present invention relates to a magnetic recording apparatus of a magnetic field modulating system and to a magnetic head drive device which is used in the magnetic recording apparatus.

### Related Background Art

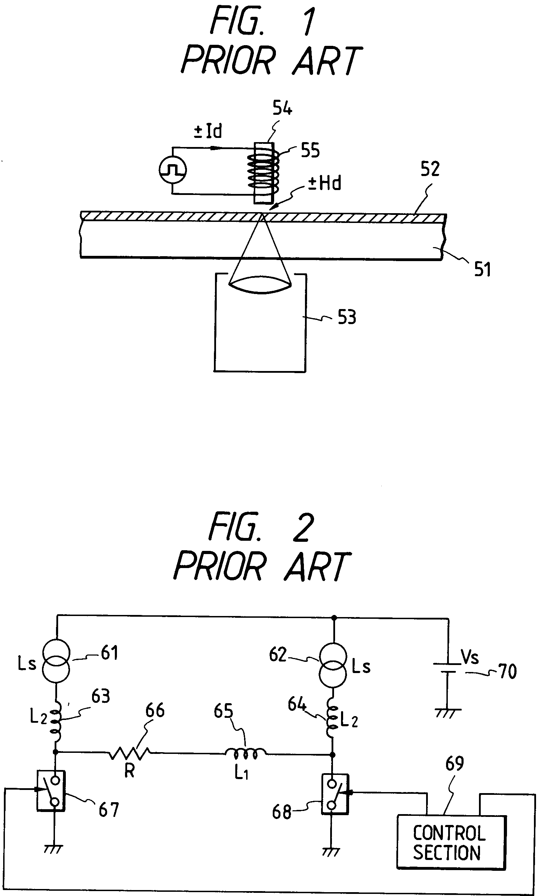

In recent years, the development of a magnetooptic recording apparatus as a memory of a low price and a large capacity which is used in a computer, an image filing system, or the like has been more and more progressed. In such a magnetooptic recording apparatus, in order to raise a recording speed, various kinds of what are called overwriting methods whereby new information is overwritten onto a magnetooptic recording medium without erasing the information which has been recorded before have been proposed. As one of such overwriting methods, there is a magnetic field modulating method proposed in JP-A-54-95250 or the like. The principle of the information recording by the magnetic field modulating method will now be described with reference to Fig. 1.

In Fig. 1, a magnetooptic recording medium 51 is constructed by forming a perpendicular magnetization film 52 onto a transparent substrate made of plastics or the like. A non-modulated light beam is irradiated onto the magnetization film 52 by an optical head 53, thereby partially heating the film 52 to a temperature near a Curie temperature. At the same time, a magnetic field $\pm H_d$ which is inverted upward and downward in accordance with an information signal is applied to the portion of the light beam irradiated magnetization film by a magnetic head 54 comprising a coil 55. The medium 51 is relatively moved for the magnetic head 54 and optical head 53 by means (not shown). When the light beam passes, therefore, a temperature of such a portion decreases and the magnetization film in this portion is magnetized in the same direction as the direction of the magnetic field applied from the magnetic head 54. During the above processes, information is recorded as a change of the magnetizing direction onto the magnetization film.

In the recording by the magnetic field modulating method, generally, it is necessary that an intensity of the magnetic field which is generated from the magnetic head is set to a large magnitude enough to record and a time which is required to switch the direction of the magnetic field, namely, a switching time is sufficiently reduced. To reduce the switching time, however, a large drive electric power is needed, so that there is a problem such that an electric power consumption of the apparatus increases.

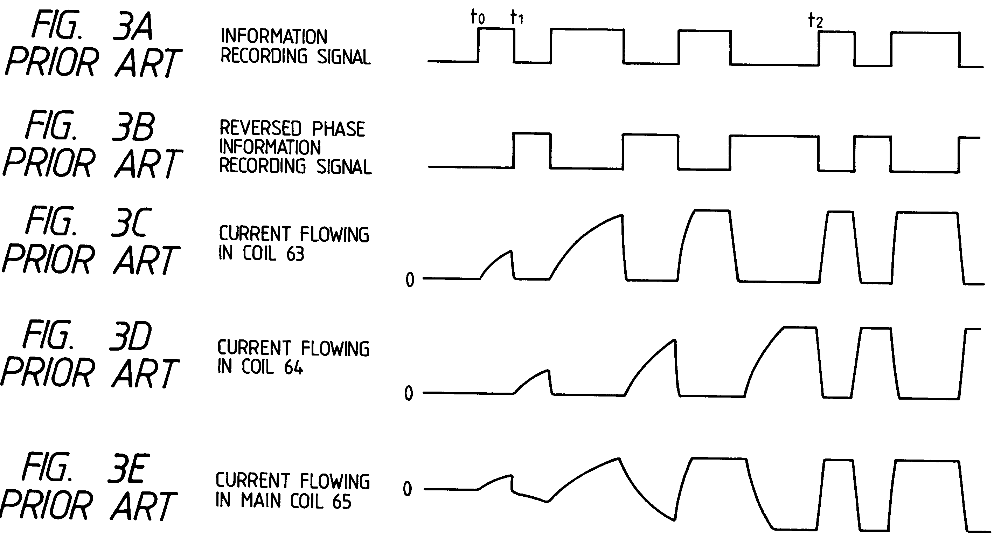

A magnetic head drive device in which the electric power consumption is decreased by providing an auxiliary coil, therefore, has been proposed in JP-A-63-94406, JP-A-3-157839, or the like. An example of such a conventional magnetic head drive device will now be described with reference to Fig. 2.

In Fig. 2, reference numeral 70 denotes a constant voltage source; 61 and 62 constant current sources; 63 and 64 auxiliary coils; 65 a main coil constructing the magnetic head; 66 a DC resistor of the main coil; 67 and 68 switching elements each for switching the direction of a current flowing in the main coil; and 69 a control section to alternately turn on/off the switching elements 67 and 68 in accordance with an information signal. In the magnetic head drive device, when the switching element 67 is turned on and the switching element 68 is turned off, a current flows into the auxiliary coil 63 through the constant current source 61 and an energy is accumulated. On the other hand, a current also flows in the main coil 65 through the constant current source 62 and auxiliary coil 64, so that a magnetic field is generated from the main coil 65. When the switching element 68 is turned on and the switching element 67 is turned off in the above state, the current flowing in the auxiliary coil 64 flows to the ground through the switching element 68. The current flowing in the auxiliary coil 63 flows into the main coil 65, thereby reversing the direction of the magnetic field which is generated from the main coil 65. Further, when the switching element 67 is turned on and the switching element 68 is turned off, the current flowing in the auxiliary coil 64 flows into the main coil 65, thereby again reversing the direction of the magnetic field. The switching time of the magnetic field is equal to the switching time of the switching elements 67 and 68, so that the magnetic field can be inverted at a high speed. By providing the auxiliary coil as mentioned above, the switching time can be reduced without increasing an electric power consumption.

In the above conventional magnetic head drive device, however, although there is no problem in a stationary state, there is a problem such that the current which is supplied to the main coil lacks for a short time from the start time point of the recording and an enough magnetic field intensity is not obtained. Figs. 3A to 3E are diagrams showing signal waveforms of respective sections in the conventional magnetic head drive device. As shown in Fig. 3A, when an information recording signal starts from a time point $t_0$, the switching element 67 is turned on/off in response to the signal of Fig. 3A. On the other hand, the switching element 68 is turned on/off in response to a reversed phase information recording signal shown in Fig. 3B. In this instance, the current flowing in the auxiliary coil 63 is not set to an enough large value for a little while from $t_0$ as shown in Fig. 3C because the switching element 67 is turned off before saturation. Similarly, the current flowing in the auxiliary coil 64 is also not set to an enough large value for a little while from $t_0$ as shown in Fig. 3D. Therefore, the current flowing in the main coil 65 is also not sufficiently supplied until a time point $t_2$ as shown in Fig. 3E. There is a fear such that the intensity of the magnetic field which is generated from the main coil lacks and information cannot be accurately recorded.

The above problem will now be explained more practically. In the magnetic head drive device of Fig. 2, a current $I_L$ flowing in the main coil 65 is expressed by the following equation.

$$I_L = 1 - \exp(-\frac{R_T}{L_H}·t) \quad (1)$$

where,

$L_H$: inductance of the magnetic head (inductance of the main coil and auxiliary coil)

$R_T$: ON-resistance of the switching element

In case of using a transistor as a switching element, the current $I_L$ of 200 mA is necessary when it is assumed that an intensity of the applied magnetic field that is necessary to record information onto the magnetooptic recording medium is equal to 200 gausses and a generation magnetic field efficiency of the magnetic head is equal to 1 (Oe/mA). Therefore, now assuming that a voltage of the DC power source 70 is set to 5 V, the ON-resistance $R_T$ of the transistor is obtained by the following equation.

$$R_T = 5V/200mA = 25\Omega \quad (2)$$

When it is now assumed that an inductance of the main coil is equal to 1.5 μH and an inductance of the auxiliary coil is equal to 100 μH, a time t which is necessary until the current $I_L(t)$ flowing in the main coil reaches 90% of 200 mA as a current in the stationary state is obtained by the following equation.

$$t = -L_H/R_T·\ln(1 - 0.9) \cong 7.6 \text{ μsec} \quad (3)$$

It is, however, assumed that DC resistances of the main coil and auxiliary coil are ignored because they are sufficiently smaller than the ON-resistance of the transistor.

Further, when it is assumed that the maximum recording frequency of the information recording signal is equal to 4 MHz and the shortest period (which is twice as long as a period of time between $t_0$ and $t_1$ in Fig. 3A) of the information recording signal is equal to 250 nsec, a time of 30 periods (7.6 μsec/250 nsec) or more is needed until the current $I_L(t)$ flowing in the main coil enters the stationary state.

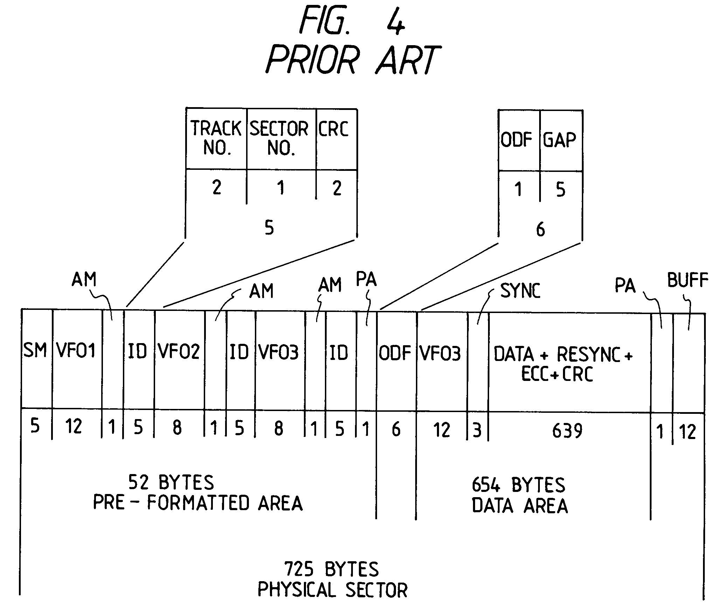

Fig. 4 is a diagram showing an example of a recording format of a magnetooptic disc. Spiral tracks are formed on the magnetooptic disc. One track is divided into a plurality of sectors. One sector is constructed as shown in Fig. 4. ID data such as sector mark SM, VFO pattern, address, and the like has previously recorded in a pre-formatted area. Information is magnetooptically recorded in ODF to PA regions in a data area. A sync signal of a predetermined frequency is recorded in, for example, a VFO3 area in the data area. In case of using the conventional magnetic head drive device, however, the magnetic field of an enough strong intensity is not applied to the magnetooptic disc for about 30 periods of the recording frequency as mentioned above. Namely, the VFO3 region consists of data of 12 bytes. In case of performing the mark position recording by using a 2-7 code, since 7.6 μsec in the above equation (3) corresponds to about 5.7 bytes, there is a possibility such that almost the former half portion of the whole VFO3 region causes a defective recording. When the VFO pattern is not accurately recorded as mentioned above, in the case where the user tries to reproduce the recorded information later, there is a fear such that the production of a read clock signal is obstructed. In addition to such a format, in the conventional magnetic head drive device, there is a fear such that troublesomeness occurs in the recording and reproduction of information due to a cause such that the magnetic field intensity just after the start of the recording is insufficient.

## SUMMARY OF THE INVENTION

It is an object of the present invention to solve the problems of the conventional technique as mentioned above and to provide a magnetic recording apparatus which can accurately record information even just after the start of the recording and a magnetic head drive device which is used in such a magnetic recording apparatus.

A magnetic head drive device according to one aspect of the present invention which can accomplish the above object comprises: a magnetic head constructed by a main coil; a power source to supply a current to the main coil; first and second auxiliary coils connected to both sides of the main coil between the power source and the main coil; first and second switching elements which are respectively serially connected to the first and second auxiliary coils and are alternately turned on/off on the basis of an information signal, in which the direction of the current flowing in the main coil is switched in correspondence to the on/off operations of the first and second switching elements; and supplying means for previously supplying the currents to the first and second auxiliary coils prior to recording information.

A magnetic recording apparatus according to one aspect of the present invention comprises: a magnetic head which is constructed by a main coil and applies a magnetic field modulated in accordance with information onto a recording medium; a power source to supply a current to the main coil; first and second auxiliary coils which are respectively connected to both sides of the main coil between the power source and the main coil; first and second switching elements which are respectively serially connected to the first and second auxiliary coils and are alternately turned on/off on the basis of an information signal, in which are direction of the current flowing in the main coil is switched in correspondence to the on/off operations of the first and second switching elements; supplying means for previously supplying the currents to the first and second auxiliary coils prior to recording information; and a motor to relatively move the recording medium for the magnetic head.

## BRIEF DESCRIPTION OF THE DRAWINGS

Fig. 1 is a schematic diagram for explaining the recording principle in a magnetooptic recording apparatus of the magnetic field modulating method;

Fig. 2 is a schematic diagram showing an example of a construction of a conventional magnetic head drive device;

Figs. 3A to 3E are diagrams showing signal waveforms of respective sections of the device of Fig. 2;

Fig. 4 is a schematic diagram showing an example of a recording format of a magnetooptic disc;

Fig. 5 is a schematic diagram showing an embodiment of a magnetooptic recording apparatus according to the present invention;

Fig. 6 is a schematic diagram showing the first embodiment of a magnetic head drive device which is used in the apparatus of Fig. 5;

Fig. 7 is a diagram showing the first embodiment of a drive signal generating circuit in Fig. 6;

Fig. 8 is a diagram showing the relations among the inputs and the output of a flip-flop circuit in Fig. 7;

Figs. 9A to 9G are diagrams showing signal waveforms in respective sections of the device of Fig. 6;

Figs. 10A to 10G are diagrams showing signal waveforms in respective sections of a modification of the device of Fig. 6;

Fig. 11 is a diagram showing the second embodiment of the drive signal generating circuit in Fig. 6;

Figs. 12A to 12H are diagrams showing signal waveforms in respective sections in case of using the circuit of Fig. 11;

Fig. 13 is a schematic diagram showing the second embodiment of a magnetic head drive device which is used in the apparatus of Fig. 5;

Fig. 14 is a diagram showing an example of a practical construction of drive signal generating circuit in Fig. 13;

Fig. 15 is a diagram showing the third embodiment of the drive signal generating circuit in Fig. 6; and

Figs. 16A to 16G are diagrams showing signal waveforms in respective sections in case of using the circuit of Fig. 15.

## DETAILED DESCRIPTION OF THE PREFERRED EMBODIMENTS

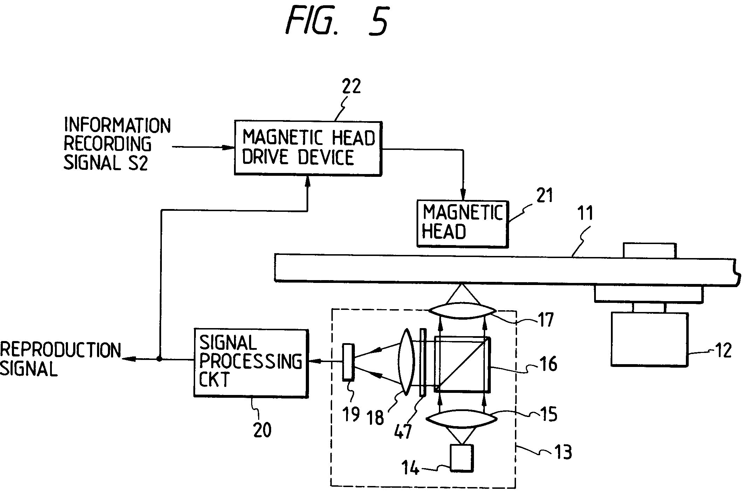

Fig. 5 is a schematic diagram showing an embodiment of a magnetooptical recording apparatus according to the present invention. In Fig. 5, a magnetooptic disc 11 is constructed by forming a magnetic layer whose axis of easy magnetization is perpendicular to the film surface onto a disc-shaped transparent substrate made of plastics or the like. A number of spiral tracks are formed on the disc 11. One circular track is divided into a plurality of sectors constructed as shown in Fig. 4.

The disc 11 is rotated by a spindle motor 12. A light beam which has been converged to a micro spot is irradiated onto a track of the rotating disc 11 from an optical head 13. The optical head 13 comprises: a semiconductor laser 14; a collimator lens 15 to collimate a light beam emitted from the semiconductor laser 14; a polarization beam splitter (PBS) 16; and an objective lens 17 to converge the light beam transmitted through the PBS onto the track. Further, the optical head 13 comprises: an analizer 47 for transmitting reflected beam which had been reflected by the disc 11 and was separated from the incident beam by the PBS; a sensor lens 18 to converge the light transmitted through the analized 47; and a photodetector 19 to receive the converged reflected beam.

On the other hand, a magnetic head 21 is arranged at a position which faces the optical head 13 so as to sandwich the disc 11. The magnetic head 21 is driven by a magnetic head drive device 22 and applies a magnetic field to a position near the portion of the disc 11 to which the light beam is applied. The direction of the magnetic field which is applied by the magnetic head 21 is switched downwardly or upwardly in accordance with an information recording signal $S_2$.

When information is recorded, a track on the disc 11 is first scanned by the light beam emitted from the optical head. The light beam in this instance is set to a low power such as not to raise a temperature of the magnetic layer of the disc to the Curie temperature. The pre-formatted area in Fig. 4 is scanned by the light beam with the low power and the reflected beam is also received by the photodetector 19. An output signal of the photodetector 19 is supplied to a signal processing circuit 20, by which a pre-formatted signal is reproduced. The reproduction signal supplied from the signal processing circuit 20 is sent to a central processing unit (CPU) (not shown) and is also supplied to the magnetic head drive device 22. The CPU judges whether the sensor which is being scanned by the light beam is a target sector or not on the basis of the track number and sector number in the reproduction signal. When it is not the target sector, the next sector is scanned by the light beam or the light beam is accessed to the target sector by moving the optical head and the magnetic head in the radial direction of the disc 11 or the like. In case of the target sector, a power of the light beam switched to a high power enough to heat the magnetic layer of the disc to a temperature near the Curie temperature and the data area shown in Fig. 4 is scanned by the light beam of such a high power. At the same time, the magnetic head 21 is driven by the magnetic head drive device 22 and the magnetic field modulated in accordance with the information recording signal $S_2$ is applied to the light beam irradiated portion of the disc 11. Information is recorded as a change in magnetizing direction of the magnetic layer in the data area as mentioned above.

In the case where the information recorded on the disc 11 is reproduced by the apparatus of Fig. 5, the pre-formatted area and the data area are scanned by the light beam of a low power. The reflected beam is received by the photodetector 19. The pre-formatted signal and the information recorded in the data area as mentioned above are reproduced by the signal processing circuit 20.

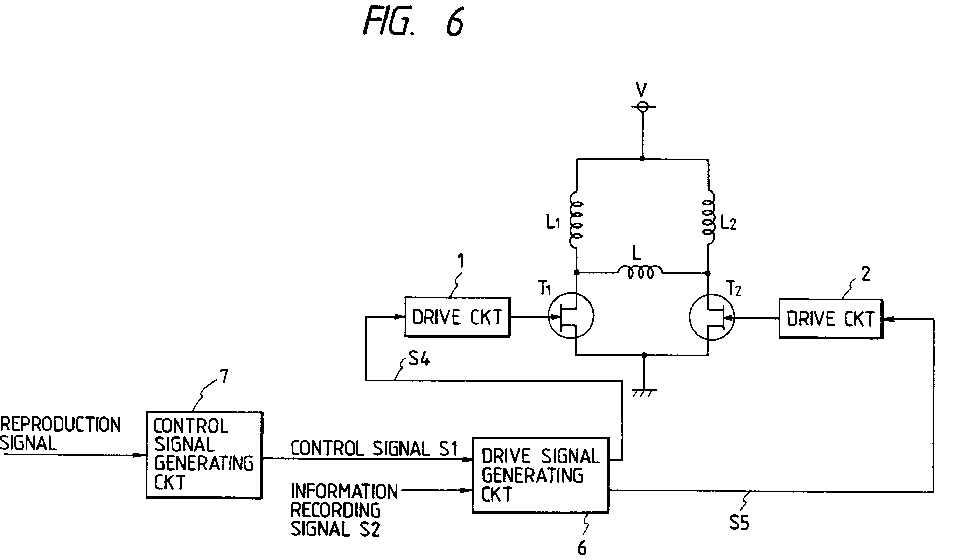

Fig. 6 is a schematic diagram showing the first embodiment of the magnetic head drive device in Fig. 5. In Fig. 6, L denotes a main coil constructing the magnetic head 21 in Fig. 5. The main coil L is formed by winding a coil around a magnetic core (not shown). A current is supplied from a DC power source V to the main coil L. A first auxiliary coil $L_1$ and a second auxiliary coil $L_2$ are connected between the power source V and the main coil L. The auxiliary coils $L_1$ and $L_2$ are respectively connected to both sides of the main coil L and are connected in parallel with the power source. Each of the auxiliary coils $L_1$ and $L_2$ has an inductance which is sufficiently larger than that of the main coil L.

Both ends of the main coil L is connected to the ground through a first field effect transistor $T_1$ and a second field effect transistor T2, respectively. The transistors $T_1$ and $T_2$, therefore, are serially connected to the auxiliary coils $L_1$ and $L_2$, respectively. The transistors $T_1$ and $T_2$ are respectively turned on/off by drive circuits 1 and 2 and construct first and second switching elements each for switching the direction of a current flowing in the main coil L. When the direction of the current is switched by the transistors $T_1$ and T2, the direction of the magnetic field which is generated from the main coil L is reversed. The auxiliary coils $L_1$ and $L_2$ have the function to reduce the switching time of the magnetic field which is generated from the main coil L in a manner similar to the function described in the prior art.

Drive signals $S_4$ and $S_5$ are supplied from a drive signal generating circuit 6 to the drive circuits 1 and 2, respectively. The transistors $T_1$ and $T_2$ are turned on/off in response to the drive signals $S_4$ and $S_5$. A control signal $S_1$ is supplied from a control signal generating circuit 7 to the drive signal generating circuit 6. The control signal generating circuit 7 generates the control signal $S_1$ on the basis of the reproduction signal of the pre-formatted area which is sent from the signal processing circuit 20 in Fig. 5. The information recording signal $S_2$ to be recorded into the data area on the disc is also supplied to the drive signal generating circuit 6. The drive signal generating circuit 6 generates the drive signals $S_4$ and $S_5$ by the information recording signal $S_2$ and the control signal $S_1$.

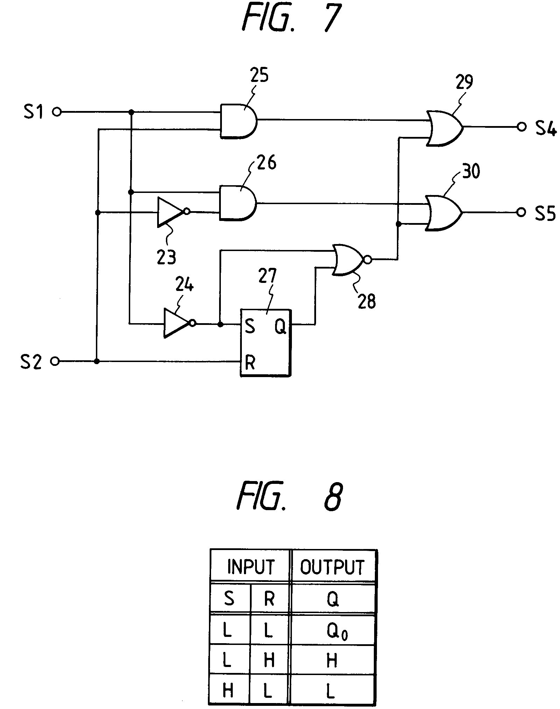

Fig. 7 is a diagram showing the first embodiment of the drive signal generating circuit 6 in Fig. 6. The driving signal generating circuit in Fig. 7 comprises: a first NOT gate 23 to generate the inverted signal of the information signal $S_2$; a second NOT gate 24 to generate the inverted signal of the control signal $S_1$; a first AND gate 25 to generate a logical multiplication signal of the information signal $S_2$ and the control signal $S_1$, the control signal $S_1$, and an AND signal; a second AND gate 26 to generate a logical multiplication signal of an output signal of the first NOT gate 23 and the control signal $S_1$; an R-S flip-flop 27 in which an output signal of the second NOT gate 24 is supplied to a set terminal S and the information signal $S_2$ is supplied to a reset terminal R, respectively; an NOR gate 28 to generate an inverted logical sum signal of an output signal of the R-S flip-flop 27 and the output signal of the second NOT gate 24; a first OR gate 29 to generate the first drive signal $S_4$ as a logical sum signal of an output signal of the first AND gate 25 and an output signal of the NOR gate 28; and a second OR gate 30 to generate the second drive signal $S_5$ as a logical sum signal of an output signal of the second AND gate 26 and the output signal of the NOR gate 28.

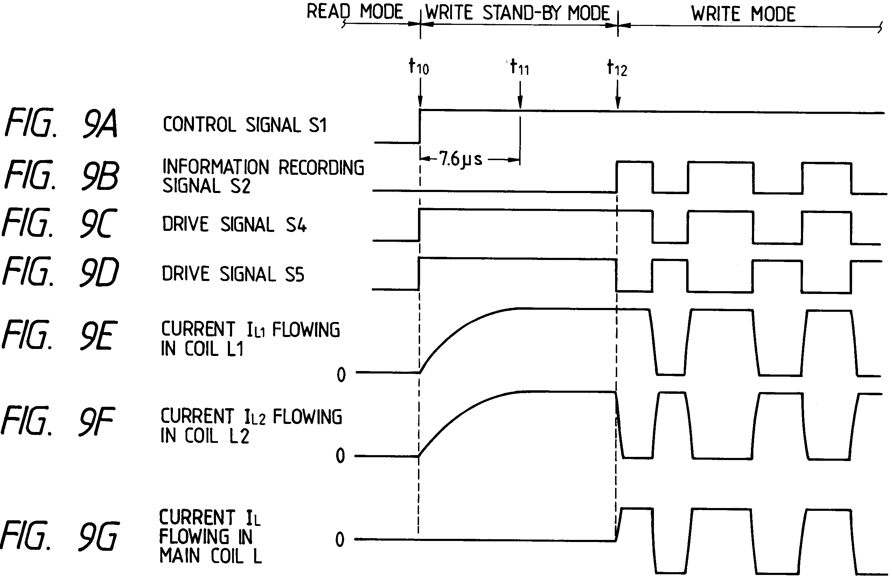

The R-S flip-flop in Fig. 7 comprises what is called a set-reset circuit which is generally well known and has the input-output relations as shown in Fig. 8. Namely, when both of the signals which are supplied to the set terminal S and reset terminal R are at the low level, an output $Q_0$ before then is maintained as it is. When the signal supplied to the set terminal S is at the low level and the signal supplied to the reset terminal R is at the high level, a high level signal is generated. When the signal supplied to the set terminal S is at the high level and the signal supplied to the reset terminal R is at the low level, a low level signal is generated.

The operation of the magnetic head drive device in Fig. 6 will now be described with reference to Figs. 9A to 9G. Figs. 9A to 9G are diagrams showing signal waveforms in respective sections in the device in Fig. 6. First, in a read mode as an ordinary reproducing mode, both of the control signal $S_1$ which is generated from the control signal generating circuit and the information recording signal $S_2$ are set to the low level as shown in Figs. 9A and 9B. The drive signals $S_4$ and $S_5$, therefore, are set to the low level as shown in Figs.

9C and 9D. The transistors $T_1$ and $T_2$ in Fig. 6 are turned off, so that no current is supplied to the auxiliary coils $L_1$ and $L_2$.

The control signal $S_1$ is subsequently changed from the low level to the high level as shown in Fig. 9A at a time point of the start of the recording, namely, at time point $t_{10}$ prior to time point $t_{12}$ at which the light beam reaches the region VFO3 in the data area shown in Fig. 4. Due to a change in control signal $S_1$, the device changes from the read mode to a write stand-by mode. The control signal $S_1$ is held at the high level until the completion of the recording. In this instance, both of the input signals to the R-S flip-flop in Fig. 7 are at the low level and the output signal is held in the preceding state $Q_0$, namely, at the low level. The output signal of the NOR gate 28 is set to the high level. Both of the drive signals $S_4$ and $S_5$ which are generated from the OR gates 29 and 30 are set to the high level.

When both of the drive signals $S_4$ and $S_5$ are set to the high level at time $t_{10}$, the drive circuits 1 and 2 in Fig. 6 turn on both of the transistors $T_1$ and $T_2$. Therefore, currents $I_{L1}$ and $I_{L2}$ shown in Figs. 9E and 9F are supplied to the auxiliary coils $L_1$ and $L_2$, respectively. Since the currents $I_{L1}$ and $I_{L2}$ flow through the transistors $T_1$ and $T_2$, they rise by time constants which are decided by inductances of the auxiliary coils and ON-resistances of the transistors as shown in Figs. 9E and 9F. In this instance, since both of the transistors $T_1$ and $T_2$ are in the ON state, no current flows in the main coil L and no magnetic field is generated as shown in Fig. 9G.

Subsequently, at recording start time point $t_{12}$, the information recording signal $S_2$ shown in Fig. 9B is supplied to the drive signal generating circuit 6, so that the operating mode is shifted from the write stand-by mode to the write mode. When the first pulse of the information recording signal $S_2$ is supplied to the reset terminal R of the R-S flip-flop 27 in Fig. 7, the output signal Q is changed to the high level. On the other hand, since the input signal to the set terminal S is held at the low level for a period of time of the write mode, the output signal Q is maintained at the high level after time $t_{12}$. Therefore, the output signal of the NOR gate 28 is set to the low level. After that, for a period of time from a time point of the end of the recording to a time point at which the operating mode is again shifted to the read mode, the drive signal generating circuit 6 generates the drive signal $S_4$ of the same phase as that of the information recording signal $S_2$ and the drive signal $S_5$ of the reversed phase of that of the information recording signal $S_2$. On the basis of those drive signals, the drive circuits 1 and 2 apply drive voltages to gates of the transistors $T_1$ and $T_2$, so that the transistors $T_1$ and $T_2$ are alternately turned on/off. When the transistor $T_1$ in ON and the transistor $T_2$ is OFF, the current from the power source V flows through the auxiliary coil $L_1$ and tran-

sistor $T_1$, so that an energy is accumulated into the auxiliary coil $L_1$. At the same time, the current flowing in the auxiliary coil $L_2$ flows into the main coil L, so that the current flows from the right to the left in Fig. 6. When the transistor $T_2$ is ON and the transistor $T_1$ is OFF, the current from the power source V flows through the auxiliary coils $L_2$ and transistor $T_2$, so that an energy is accumulated into the auxiliary coil $L_2$. At the same time, the current flowing in the auxiliary coil $L_1$ flows in the main coil L, so that the current flows from the left to the right in Fig. 6. As mentioned above, due to the switching operations of the transistors $T_1$ and $T_2$, an alternating current whose direction is switched in response to the information recording signal $S_2$ flows in the main coil L as shown in Fig. 9G. Consequently, the magnetic field whose polarity is switched in accordance with the information recording signal $S_2$ is applied to the magnetooptic disc 11 from the magnetic head 21 comprising the main coil L, so that information is recorded.

In the above embodiment, the magnetic head is driven by alternately supplying the energy accumulated in the auxiliary coils $L_1$ and $L_2$ of a large inductance to the main coil. Therefore, the switching time of the magnetic head can be reduced without increasing an electric power consumption. On the other hand, since the current is supplied to the auxiliary coil prior to starting the recording, an enough large amount of energy has been accumulated into the auxiliary coil at the time point of the start of the recording. As shown in Fig. 9G, therefore, the current of a necessary enough large magnitude flows in the main coil simultaneously with the start of the recording and information can be recorded by a predetermined magnetic field intensity. According to the embodiment, therefore, a situation such that the magnetic field intensity lacks just after the start of the recording as in the conventional apparatus doesn't occur and the information can be always accurately recorded.

In the above embodiment, it is desirable that the time point $t_{10}$ at which the control signal $S_1$ is set to the high level is set to a time which is sufficiently earlier than the time point $t_{12}$ of the start of the recording. That is, it is preferable that a period of time between $t_{10}$ and $t_{12}$ is set to be longer than a period of time between $t_{10}$ and $t_{11}$ which is necessary for the current flowing in the auxiliary coil to be saturated. For instance, in the example described in the conventional technique, since a time of about 7.6 μsec is required until the current value reaches 90% of the stationary value, in such a case, it is desirable to set the period of time between $t_{10}$ and $t_{12}$ to 7.6 μsec or longer. A further specific example will now be described. Since 7.6 μsec corresponds to about 5.7 bytes, in case of using the medium of the format shown in Fig. 4, it is proper to switch the control signal $S_1$ from the low level to the high level at the timing at which the light beam reaches the head of the ODF region as a one-preceding region of the VFO3 region, namely, the last of the pre-formatted region. In this case, the control signal generating circuit 7 in Fig. 6 can generate the control signal $S_1$ by detecting the last of the pre-formatted area from the reproduction signal which is sent from the signal processing circuit 20.

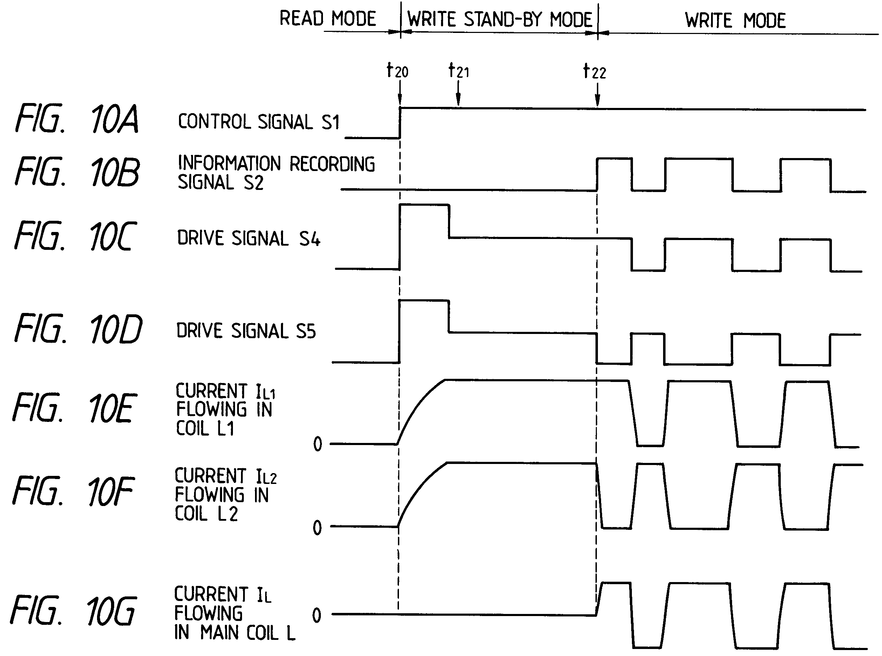

In the above embodiment, the voltage of the drive signal in the write stand-by mode has been set to a predetermined value. However, by setting the voltage of the drive signal at the start time point of the write stand-by mode to a value higher than the voltage at the end of the write stand-by mode, the current flowing in the auxiliary coil can be raised early. Such an example will now be described with reference to Figs. 10A to 10G.

In such an example, as shown in Figs. 10C and 10D, the drive signal of a level higher than that at time point $t_{22}$ is generated for a period of time from time point $t_{20}$ at which the control signal $S_1$ is set to the high level to time point $t_{21}$ at which a predetermined time elapses from $t_{20}$. Therefore, a gate current of a large voltage is applied to the transistors $T_1$ and $T_2$ for a period of time from $t_{20}$ to $t_{21}$ and a current larger than that at time point $t_{22}$ flows across the drain and source of each of those transistors $T_1$ and $T_2$. Consequently, a resistance between the drain and source (ON-resistance) of each of the transistors $T_1$ and $T_2$ decreases. Since a time constant to raise the current is determined by the inductance of the auxiliary coil and the ON-resistance, when the ON-resistance decreases, the time constant is also reduced. As shown in Figs. 10E and 10F, the time which is necessary for allowing the current flowing in the auxiliary coil to be saturated can be reduced. For instance, when the current flowing in the transistors for a period of time between $t_{20}$ and $t_{21}$ is doubled, the time which is required until the current is set into the stationary state (saturated state) can be reduced into 1/2. In the example, there are advantages such that the time in the write stand-by mode can be reduced and the magnetic head can be set into the recordable state more early.

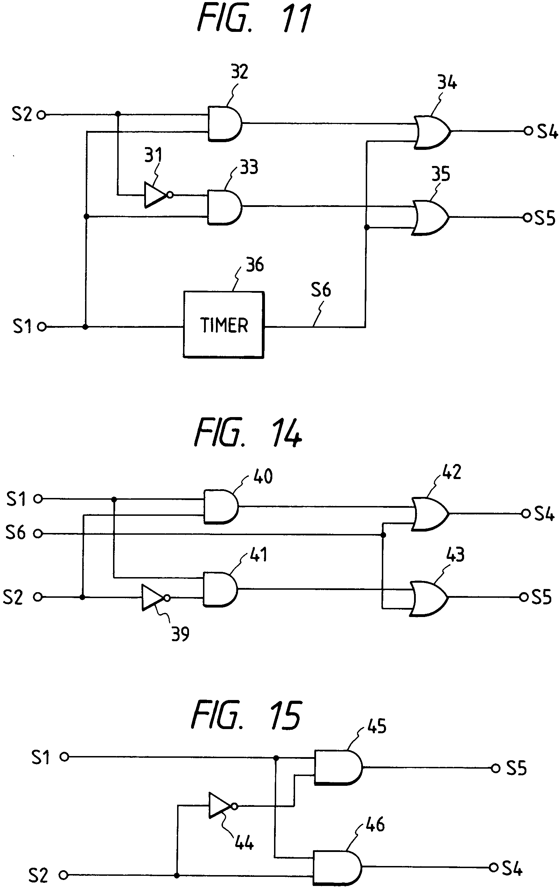

Fig. 11 is a diagram showing the second embodiment of the drive signal generating circuit of Fig. 6. In the embodiment, the portions other than the drive signal generating circuit are constructed in a manner similar to those in the first embodiment shown in Figs. 5 and 6. The drive signal generating circuit of Fig. 11 comprises: a timer 36 to generate another control signal $S_6$ from the control signal $S_1$; an NOT gate 31 to generate the inverted signal of the information recording signal $S_2$; a first AND gate 32 to generate an AND (logical multiplication) signal of the information recording signal $S_2$ and the control signal $S_1$; a second AND gate 33 to generate an AND signal of an output signal of the NOT gate 31 and the control signal $S_1$; a first OR gate 34 to generate, as a drive signal $S_4$, an OR (logical sum) signal of an output signal of the first AND gate 32 and the control signal $S_6$; and

the second OR gate 35 to generate, as a drive signal $S_5$, an OR signal of an output signal of the second AND gate 33 and the control signal $S_6$.

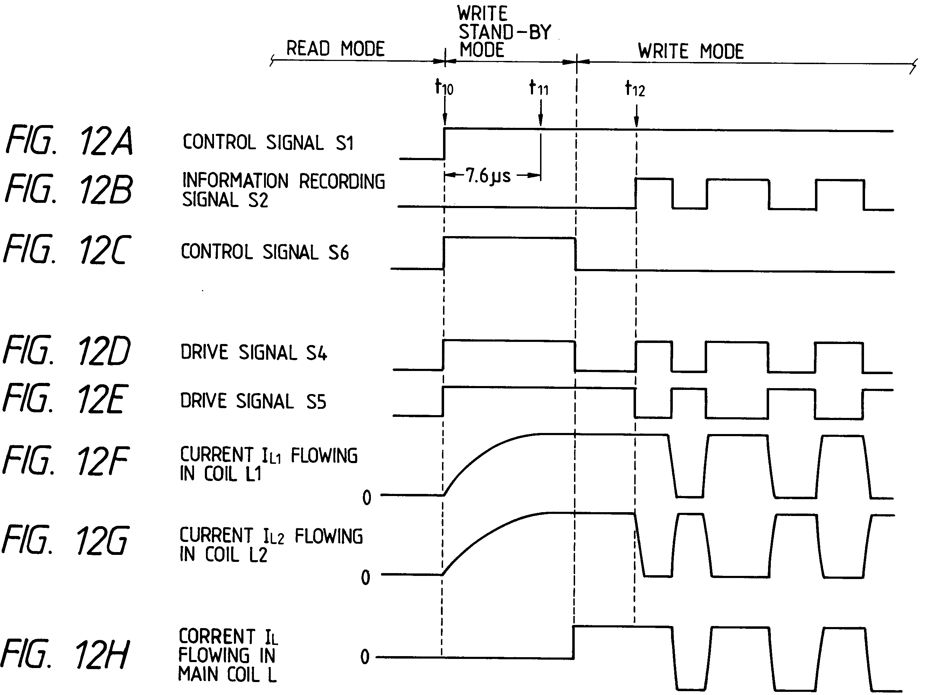

Figs. 12A to 12G are diagrams showing signal waveforms in respective sections in the magnetic head drive device in case of using the circuit of Fig. 11. The embodiment differs from the first embodiment with respect to a point that the control signal $S_6$ which is set to the high level for only a period of time of the write stand-by mode shown in Fig. 12C is generated from the control signal $S_1$ shown in Fig. 12A. The control signal $S_6$ is set to the high level simultaneously with that the control signal $S_1$ is set to the high level. The control signal $S_6$ is set to the low level before time point $t_{12}$ of the start of the recording. The drive signals $S_4$ and $S_5$ are set to the high level for a period of time during which the control signal $S_6$ is at the high level as shown in Figs. 12D and 12E, thereby allowing the current to be supplied to the auxiliary coils $L_1$ and $L_2$ as shown in Figs. 12F and 12E. When the control signal $S_6$ is set to the low level, the drive signal $S_4$ is set to the low level and the drive signal $S_5$ is held at the high level.

In the embodiment as well, since the current in the stationary state (saturated state) is supplied to the auxiliary coils $L_1$ and $L_2$ prior to starting the recording, information can be accurately recorded simultaneously with the start of the recording in a manner similar to the first embodiment. In the embodiment, as shown in Fig. 12H, the current flows in the main coil L before the recording start time point $t_{12}$ and the magnetic field is generated. However, since the power of the light beam is low before time point $t_{12}$, no adverse influence is exerted on the recording of the information.

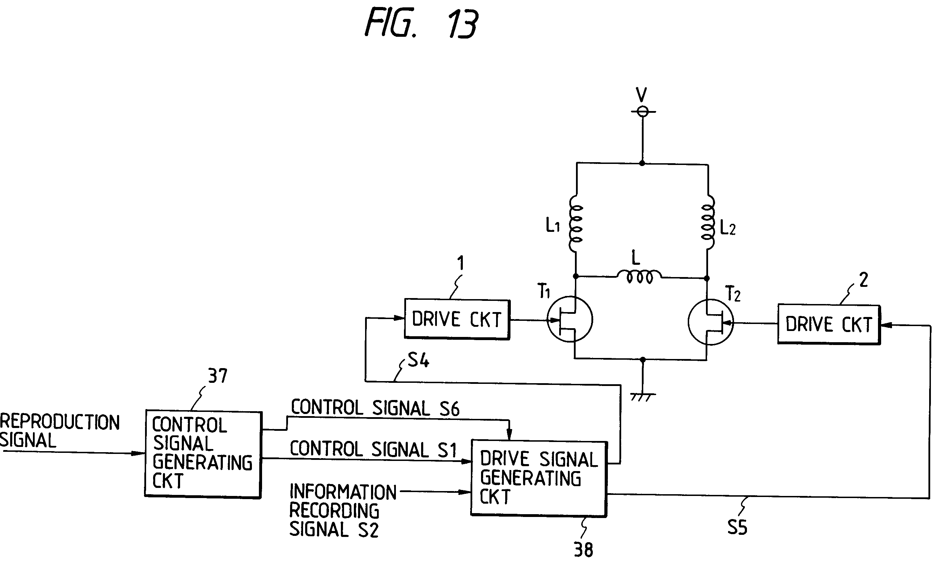

In the embodiment of Fig. 11, the control signal $S_6$ has been generated from the drive signal generating circuit. However, such a control signal $S_6$ can be also generated from the control signal generating circuit. Such an example will now be described with reference to Fig. 13. Fig. 13 is a schematic diagram showing the second embodiment of the magnetic head drive device. In Fig. 13, the same component elements as those shown in Fig. 6 are designated by the same reference numerals and their detailed descriptions are omitted here. The respective sections of the device of Fig. 13 operate as shown in Figs. 12A to 12G in a manner similar to the embodiment of Fig. 11.

In the device of Fig. 13, a control signal generating circuit 37 generates the control signals $S_1$ and $S_6$ as shown in Figs. 12A and 12C on the basis of the reproduction signal which is supplied from the signal processing circuit 20 in Fig. 5. Those control signals are supplied to a drive signal generating circuit 38, from which the drive signals $S_4$ and $S_5$ as shown in Figs. 12D and 12E are generated. As shown in Fig. 14, the drive signal generating circuit 38 comprises:

an NOT gate 39 to generate the inverted signal of the information recording signal $S_2$; a first AND gate 40 to generate an AND signal of the information signal $S_2$ and the first control signal $S_1$; a second AND gate 41 to generate an AND signal of an output signal of the NOT gate 39 and the first control signal $S_1$; a first OR gate 42 to generate, as a drive signal $S_4$, an OR signal of an output signal of the first AND gate 40 and the second control signal $S_6$; and a second OR gate 43 to generate, as a drive signal $S_5$, an OR signal of an output signal of the second AND gate 41 and the second control signal $S_6$. In the embodiment as well, an effect similar to that in the foregoing embodiment can be derived.

In the above embodiments, both of the transistors $T_1$ and $T_2$ have been turned on prior to recording information. However, even when only the transistor $T_2$ is turned on, a similar effect is obtained. Such an example will now be described with reference to Fig. 15.

Fig. 15 is a diagram showing the third embodiment of the drive signal generating circuit of Fig. 6. In the embodiment, the portions other than the drive signal generating circuit are constructed in a manner similar to the first embodiment shown in Figs. 5 and 6. A drive signal generating circuit of Fig. 15 comprises: an NOT gate 44 to generate the inverted signal of the information recording signal $S_2$; a first AND gate 46 to generate, as a drive signal $S_4$, an AND signal of the information recording signal $S_2$ and the control signal $S_1$; and a second AND gate 45 to generate, as a drive signal $S_5$, an AND signal of an output signal of the NOT gate 44 and the control signal $S_1$.

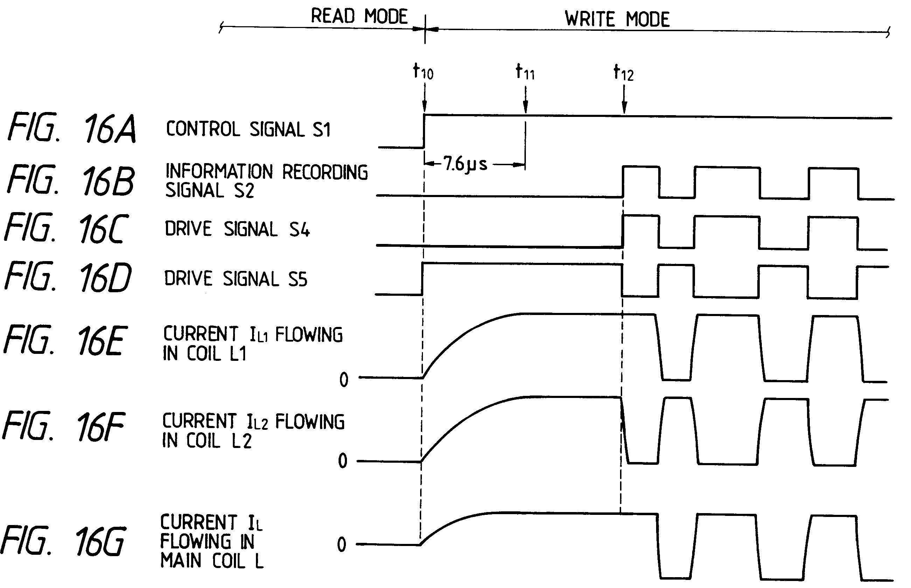

Figs. 16A to 16G are diagrams showing signal waveforms in respective sections of the magnetic head drive device in case of using the circuit of Fig. 15. In the embodiment, on the basis of the control signal $S_1$ shown in Fig. 16A, the drive signal $S_5$ is set to the high level and the transistor $T_2$ is turned on prior to recording information as shown in Fig. 16D. On the other hand, the drive signal is maintained at the low level until the recording start time point $t_{12}$ as shown in Fig. 16C, so that the transistor $T_1$ is held in the OFF state.

When the transistor $T_2$ is turned on prior to recording information, the current flows from the power source V through the auxiliary coil $L_2$ and transistor $T_2$ in Fig. 6 and the current flowing in the auxiliary coil $L_2$ rises as shown in Fig. 16F. On the other hand, the current from the power source V also flows from a route of the auxiliary coil $L_1$, main coil L, and transistor $T_2$. The current flowing in the auxiliary coil $L_1$, consequently, also rises as shown in Fig. 16E. When the recording is started at time point $t_{12}$, the drive signals $S_4$ and $S_5$ are modulated in accordance with the information recording signal $S_2$ shown in Fig. 16B and the transistors $T_1$ and $T_2$ are alternately turned on/off, so that an alternating current flows in the main coil L as shown in Fig. 16G.

In the embodiment as well, since the current in the stationary state (saturated state) is supplied to the auxiliary coils $L_1$ and $L_2$ prior to starting the recording, information can be accurately recorded simultaneously with the start of the recording in a manner similar to the first embodiment. In the embodiment, as shown in Fig. 16G, the current flows in the main coil L before the recording start time point $t_{12}$ and the magnetic field is generated. However, since the power of the light beam is low before time point $t_{12}$, no adverse influence is exerted on the recording of information.

According to the present invention as described above, since the current is previously supplied to the auxiliary coils prior to recording information, there are advantages such that the current of the main coil doesn't lack just after the start of the recording and the defective recording can be prevented.

The present invention is not limited to the foregoing embodiments but many modifications and variations are possible within the spirit and scope of the appended claims of the invention. For instance, although the embodiments have been described by using the magnetooptic recording apparatus, the magnetic head drive device of the present invention can be also applied to a magnetic recording apparatus such as a magnetic disc device which records information without using an optical head or the like. The present invention incorporates all of the application examples as mentioned above without departing from the scope of claims of the invention.

## Claims

1. A magnetic head drive device which is used in a magnetic recording apparatus for recording information onto a recording medium by a magnetic head, comprising:

   a magnetic head comprising a main coil;

   a power source to supply a current to said main coil;

   first and second auxiliary coils which are respectively connected to both sides of the main coil between said power source and said main coil;

   first and second switching elements which are respectively serially connected to said first and second auxiliary coils and are alternately turned on/off on the basis of an information signal, in which the direction of the current flowing in the main coil is switched in correspondence to the on/off operations of said first and second switching elements; and

   supplying means for previously supplying the current to the first and second auxiliary coils prior to recording the information.

2. A device according to claim 1, wherein said supplying means comprises a drive signal generating circuit to turn on the first and second switching elements for a predetermined period of time before the recording of the information is started.

3. A device according to claim 2, wherein at a start time point of said predetermined period of time, said drive signal generating circuit applies to said first and second switching elements a drive signal of a voltage higher than a voltage of a drive signal which is applied to the first and second switching elements at an end time point of the predetermined period of time.

4. A device according to claim 2, further comprising a control signal generating circuit to supply a control signal indicative of a start timing of said predetermined period of time to said drive signal generating circuit.

5. A device according to claim 4, wherein said recording medium has a data area in which the information is recorded and a pre-formatted area added before said data area, and said control signal generating circuit generates the control signal on the basis of a reproduction signal of the pre-formatted area which is reproduced by reproducing means of said magnetic recording apparatus.

6. A device according to claim 4, wherein said drive signal generating circuit comprises:

a first NOT gate to generate the inverted signal of the information signal;

a second NOT gate to generate the inverted signal of the control signal;

a first AND gate to generate an AND signal of the information signal and the control signal;

a second AND gate to generate an AND signal of an output signal of said first NOT gate and the control signal;

an R-S flip-flop in which an output signal of said second NOT gate is supplied to a set terminal and the information signal is supplied to a reset terminal, respectively;

an NOR gate to generate an inverted OR signal of an output signal of said R-S flip-flop and the output signal of said second NOT gate;

a first OR gate to supply an OR signal of the output signal of the first AND gate and an output signal of said NOR gate to said first switching element; and

a second OR gate to supply an OR signal of an output signal of said second AND gate and the output signal of the NOR gate to said second switching element.

7. A device according to claim 4, wherein said drive signal generating circuit comprises:

a timer to generate from said control signal another control signal which is set to the high level simultaneously with that the control signal is set to the high level and which is set to the low level during a predetermined period of time;

an NOT gate to generate the inverted signal of the information signal;

a first AND gate to generate an AND signal of the information signal and the control signal;

a second AND gate to generate an AND signal of an output signal of said NOT gate and the control signal;

a first OR gate to supply an OR signal of an output signal of said first AND gate and said another control signal to said first switching element; and

a second OR gate to supply an OR signal of an output signal of said second AND gate and said another control signal to said second switching element.

8. A device according to claim 2, further comprising a control signal generating circuit to supply to said drive signal generating circuit a first control signal indicative of a start timing of said predetermined period of time and a second control signal which is set to the high level simultaneously with that the first control signal is set to the high level and which is set to the low level during said predetermined period of time.

9. A device according to claim 8, wherein said recording medium has a data area in which the information is recorded and a pre-formatted area added before said data area, and said control signal generating circuit generates the control signal on the basis of a reproduction signal of said pre-formatted area which is reproduced by reproducing means of said magnetic recording apparatus.

10. A device according to claim 8, wherein said drive signal generating circuit comprises:

an NOT gate to generate the inverted signal of the information signal;

a first AND gate to generate an AND signal of the information signal and the first control signal;

a second AND gate to generate an AND signal of an output signal of said NOT gate and the first control signal;

a first OR gate to supply an OR signal of an output signal of said first AND gate and the second control signal to said first switching element; and

a second OR gate to supply an OR signal of an output signal of said second AND gate and the second control signal to said second switching element.

**11.** a device according to claim 1, wherein said supplying means comprises a drive signal generating circuit to turn on only the second switching element for a predetermined period of time before the recording of the information is started.

**12.** A device according to claim 11, further comprising a control signal generating circuit to supply a control signal indicative of a start timing of said predetermined period of time to said drive signal generating circuit.

**13.** A device according to claim 12, wherein said recording medium has a data area in which the information is recorded and a pre-formatted area added before said data area, and said control signal generating circuit generates the control signal on the basis of a reproduction signal of the pre-formatted area which is reproduced by reproducing means of said magnetic recording apparatus.

**14.** A device according to claim 11, wherein said drive signal generating circuit comprises:
an NOT gate to generate the inverted signal of the information signal;
a first AND gate to supply an AND signal of the information signal and the control signal to said second switching element; and
a second AND gate to supply an AND signal of an output signal of said NOT gate and the control signal to said first switching element.

**15.** A device according to claim 1, wherein said first and second switching elements comprise first and second transistors.

**16.** A method of driving a magnetic head drive device that is used in a magnetic recording apparatus which comprises a magnetic head constructed by a main coil, a power source to supply a current to said main coil, first and second auxiliary coils which are respectively connected to both sides of said main coil between said power source and said main coil, and first and second switching elements which are respectively serially connected to said first and second auxiliary coils and in which information is recorded onto a recording medium by said magnetic head, wherein said method comprises the steps of:
previously supplying a current to the first and second auxiliary coils prior to recording the information; and
switching the direction of the current flowing in the main coil by alternately turning on/off the first and second switching elements on the basis of the information signal.

**17.** A method according to claim 16, further comprising the step of turning on the first and second switching elements for a predetermined period of time before the recording of the information is started.

**18.** A method according to claim 17, wherein at a start time point of said predetermined period of time, a drive signal of a voltage which is higher than a voltage of a drive signal which is applied to the first and second switching elements at an end time point of said predetermined period of time is supplied to the first and second switching elements.

**19.** A method according to claim 17, further comprising the step of generating a control signal indicative of a start timing of said predetermined period of time.

**20.** A method according to claim 19, wherein said recording medium has a data area in which the information is recorded and a pre-formatted area added before said data area, and said control signal is produced on the basis of a reproduction signal of the pre-formatted area which is reproduced by reproducing means of said magnetic recording apparatus.

**21.** A method according to claim 16, further comprising the step of turning on only the second switching element for a predetermined period of time before the recording of the information is started.

**22.** A method according to claim 21, further comprising the step of generating a control signal indicative of a start timing of said predetermined period of time.

**23.** A method according to claim 22, wherein said recording medium has a data area in which the information is recorded and a pre-formatted area added before said data area, and said control signal is produced on the basis of a reproduction signal of the pre-formatted area which is reproduced by reproducing means of said magnetic recording apparatus.

**24.** A magnetic recording apparatus for recording information onto a recording medium by a magnetic head, comprising:
a magnetic head which comprises a main coil and applies a magnetic field modulated in accordance with information onto the recording medium;
a power source to supply a current to the main coil;
first and second auxiliary coils connected to both sides of said main coil between said power source and said main coil;

first and second switching elements which are serially connected to said first and second auxiliary coils and are alternately turned on/off on the basis of an information signal, in which the direction of the current flowing in the main coil is switched in correspondence to the on/off operations of said first and second switching elements;

supplying means for previously supplying the current to the first and second auxiliary coils prior to the recording of the information; and

a motor to relatively move the recording medium for the magnetic head.

25. An apparatus according to claim 24, wherein said supplying means comprises a drive signal generating circuit to turn on the first and second switching elements for a predetermined period of time before the recording of the information is started.

26. An apparatus according to claim 25, wherein at a start time point of said predetermined period of time, said drive signal generating circuit supplies a drive signal of a voltage higher than a voltage of a drive signal which is applied to the first and second switching elements at an end time point of said predetermined period of time to said first and second switching elements.

27. An apparatus according to claim 25, further comprising a control signal generating circuit to supply a control signal indicative of a start timing of said predetermined period of time to said drive signal generating circuit.

28. An apparatus according to claim 27, wherein said recording medium has a data area in which the information is recorded and a pre-formatted area which is added before said data area and in which a pre-formatted signal has been recorded, said apparatus further has reproducing means for reproducing the pre-formatted signal on said recording medium, and said control signal generating circuit generates the control signal on the basis of the pre-formatted signal which is reproduced by said reproducing means.

29. An apparatus according to claim 27, wherein said drive signal generating circuit comprises:

a first NOT gate to generate the inverted signal of said information signal;

a second NOT gate to generate the inverted signal of said control signal;

a first AND gate to generate an AND signal of said information signal and said control signal;

a second AND gate to generate an AND signal of an output signal of said first NOT gate and the control signal;

an R-S flip-flop in which an output signal of said second NOT gate is supplied to a set terminal and the information signal is supplied to a reset terminal, respectively;

an NOR gate to generate an inverted OR signal of an output signal of said R-S flip-flop and the output signal of said second NOT gate;

a first OR gate to supply an OR signal of the output signal of the first AND gate and an output signal of said NOR gate to said first switching element; and

a second OR gate to supply an OR signal of an output signal of said second AND gate and the output signal of said NOR gate to said second switching element.

30. An apparatus according to claim 27, wherein said drive signal generating circuit comprises:

a timer to generate from a control signal another control signal which is set to the high level simultaneously with that said control signal is set to the high level and which is set to the low level during a predetermined period of time;

an NOT gate to generate the inverted signal of the information signal;

a first AND gate to generate an AND signal of said information signal and said control signal;

a second AND gate to generate an AND signal of an output signal of said NOT gate and the control signal;

a first OR gate to supply an OR signal of an output signal of said first AND gate and said another control signal to said first switching element; and

a second OR gate to supply an OR signal of an output signal of said second AND gate and said another control signal to said second switching element.

31. An apparatus according to claim 25, further comprises a control signal generating circuit to supply to said drive signal generating circuit a first control Signal indicative of a start timing of said predetermined period of time and a second control signal which is set to the high level simultaneously with that said first control signal is set to the high level and which is set to the low level during said predetermined period of time.

32. An apparatus according to claim 31, wherein said recording medium has a data area in which the information is recorded and a pre-formatted area added before said data area, and said control signal generating circuit generates the control signal on the basis of a reproduction signal of said pre-formatted area which is reproduced by reproducing means of said magnetic recording apparatus.

33. An apparatus according to claim 31, wherein said drive signal generating circuit comprises:

an NOT gate to generate the inverted signal of said information signal;

a first AND gate to generate an AND signal of said information signal and said first control signal;

a second AND gate to generate an AND signal of an output signal of said NOT gate and said first control signal;

a first OR gate to supply an OR signal of an output signal of said first AND gate and said second control signal to said first switching element; and

a second OR gate to supply an OR signal of an output signal of said second AND gate and said second control signal to said second switching element.

34. An apparatus according to claim 24, wherein said supplying means comprises a drive signal generating circuit to turn on the second switching element for a predetermined period of time before the recording of the information is started.

35. An apparatus according to claim 34, further comprising a control signal generating circuit to supply a control signal indicative of a start timing of said predetermined period of time to said drive signal generating circuit.

36. An apparatus according to claim 35, wherein said recording medium has a data area in which the information is recorded and a pre-formatted area added before said data area, and said control signal generating circuit generates the control signal on the basis of a reproduction signal of the pre-formatted area which is reproduced by reproducing means of said magnetic recording apparatus.

37. An apparatus according to claim 34, wherein said drive signal generating circuit comprises:

an NOT gate to generate the inverted signal of said information signal;

a first AND gate to supply an AND signal of said information signal and said control signal to said second switching element; and

a second AND gate to supply an AND signal of an output signal of said NOT gate and said control signal to said first switching element.

38. An apparatus according to claim 24, wherein said first and second switching elements comprises first and second transistors, respectively.

39. An apparatus according to claim 24, further comprising an optical head to irradiate a light beam to a portion of the recording medium to which a magnetic field is applied to said magnetic head.

40. An apparatus according to claim 39, wherein said optical head comprises:

a light source;

an objective lens to converge a light beam emitted from said light source onto the recording medium; and

a photodetector to detect the light beam reflected by the recording medium.

41. An apparatus according to claim 40, further comprises a signal processing circuit to reproduce the information recorded on the recording medium from an output signal of said photodetector.

42. An apparatus according to claim 24, wherein said recording medium comprises a magnetooptic disc and said motor comprises a spindle motor to rotate the magnetooptic disc.

43. A method of recording information to a recording medium by a magnetic recording apparatus comprising a magnetic head comprising a main coil, a power source to supply a current to said main coil, first and second auxiliary coils connected to both sides of said main coil between said power source and said main coil, first and second switching elements which are respectively serially connected to said first and second auxiliary coils, and a motor, wherein the method comprises the steps of:

relatively moving the recording medium for the magnetic head by a motor;

previously supplying a current to said first and second auxiliary coils prior to recording the information;

applying a magnetic field to the recording medium by supplying a current into said main coil; and

switching the direction of the current flowing in the main coil by alternately turning on/off the first and second switching elements on the basis of an information signal.

44. A method according to claim 43, further comprising the step of turning on the first and second switching elements for a predetermined period of time before the recording of the information is started.

45. A method according to claim 44, wherein at a start time point of said predetermined period of time, a drive signal of a voltage higher than a voltage of a drive signal which is applied to the first and second switching elements at an end time point of said predetermined period of time is applied to the first and second switching elements.

**46.** A method according to claim 45, further comprising the step of generating a control signal indicative of the start timing of said predetermined period of time.

**47.** A method according to claim 46, wherein said recording medium has a data area in which the information is recorded and a pre-formatted area added before said data area, and said control signal is produced on the basis of a reproduction signal of the pre-formatted area which is reproduced by reproducing means of said magnetic recording apparatus.

**48.** A method according to claim 43, further comprising the step of turning on only the second switching element for a predetermined period of time before the recording of the information is started.

**49.** A method according to claim 48, further comprising the step of generating a control signal indicative of a start timing of said predetermined period of time.

**50.** A method according to claim 49, wherein said recording medium has a data area in which information is recorded and a pre-formatted area added before said data area, and said control signal is generated on the basis of a reproduction signal of the pre-formatted area which is reproduced by reproducing means of said magnetic recording apparatus.

**51.** A magnetic head drive device for use in a recording apparatus, including a main recording coil and at least one auxiliary coil, wherein the device includes means for supplying current to the auxiliary coil prior to the recording of a recording signal on a recording medium by the main recording coil.

**52.** A method of recording a recording signal on a recording medium including supplying current to at least one auxiliary coil prior to using a main recording coil to record said recording signal.

# FIG. 1
## PRIOR ART

# FIG. 2
## PRIOR ART

**FIG. 3A PRIOR ART** — INFORMATION RECORDING SIGNAL

$t_0$ $t_1$ $t_2$

**FIG. 3B PRIOR ART** — REVERSED PHASE INFORMATION RECORDING SIGNAL

**FIG. 3C PRIOR ART** — CURRENT FLOWING IN COIL 63

0

**FIG. 3D PRIOR ART** — CURRENT FLOWING IN COIL 64

0

**FIG. 3E PRIOR ART** — CURRENT FLOWING IN MAIN COIL 65

0

FIG. 4
PRIOR ART

EP 0 557 094 A1

# FIG. 5

INFORMATION
RECORDING
SIGNAL S2

MAGNETIC HEAD
DRIVE DEVICE

22

MAGNETIC
HEAD

21

11

12

REPRODUCTION
SIGNAL

SIGNAL
PROCESSING
CKT

20

19 18

47

17

16

15

13

14

EP 0 557 094 A1

## FIG. 6

FIG. 7

FIG. 8

| INPUT | | OUTPUT |
|---|---|---|
| S | R | Q |
| L | L | $Q_0$ |
| L | H | H |
| H | L | L |

$t_{10}$    $t_{11}$    $t_{12}$

FIG. 9A    CONTROL SIGNAL S1

FIG. 9B    INFORMATION RECORDING
SIGNAL S2

$\leftarrow$ 7.6μs $\rightarrow$

FIG. 9C    DRIVE SIGNAL S4

FIG. 9D    DRIVE SIGNAL S5

FIG. 9E    CURRENT $I_{L1}$ FLOWING
IN COIL L1

0

FIG. 9F    CURRENT $I_{L2}$ FLOWING
IN COIL L2

0

FIG. 9G    CURRENT $I_L$
FLOWING IN
MAIN COIL L

0

EP 0 557 094 A1

FIG. 10A — CONTROL SIGNAL S1

FIG. 10B — INFORMATION RECORDING SIGNAL S2

FIG. 10C — DRIVE SIGNAL S4

FIG. 10D — DRIVE SIGNAL S5

FIG. 10E — CURRENT $I_{L1}$ FLOWING IN COIL L1

FIG. 10F — CURRENT $I_{L2}$ FLOWING IN COIL L2

FIG. 10G — CURRENT $I_L$ FLOWING IN MAIN COIL L

READ MODE | WRITE STAND-BY MODE | WRITE MODE

$t_{20}$  $t_{21}$  $t_{22}$

EP 0 557 094 A1

# FIG. 11

# FIG. 14

# FIG. 15

READ MODE | WRITE STAND-BY MODE | WRITE MODE

$t_{10}$ $t_{11}$ $t_{12}$

FIG. 12A — CONTROL SIGNAL S1

FIG. 12B — INFORMATION RECORDING SIGNAL S2

7.6 µs

FIG. 12C — CONTROL SIGNAL S6

FIG. 12D — DRIVE SIGNAL S4

FIG. 12E — DRIVE SIGNAL S5

FIG. 12F — CURRENT $I_{L1}$ FLOWING IN COIL L1

0

FIG. 12G — CURRENT $I_{L2}$ FLOWING IN COIL L2

0

FIG. 12H — CORRENT $I_L$ FLOWING IN MAIN COIL L

0

FIG. 13

EP 0 557 094 A1

FIG. 16A  CONTROL SIGNAL S1

FIG. 16B  INFORMATION RECORDING SIGNAL S2

FIG. 16C  DRIVE SIGNAL S4

FIG. 16D  DRIVE SIGNAL S5

FIG. 16E  CURRENT $I_{L1}$ FLOWING IN COIL L1

FIG. 16F  CURRENT $I_{L2}$ FLOWING IN COIL L2

FIG. 16G  CURRENT $I_L$ FLOWING IN MAIN COIL L

READ MODE   WRITE MODE

$t_{10}$   $t_{11}$   $t_{12}$

7.6 μs

EP 0 557 094 A1

European Patent Office

**EUROPEAN SEARCH REPORT**

Application Number

EP 93 30 1197

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | PATENT ABSTRACTS OF JAPAN vol. 13, no. 54 (P-824)(3402) 8 February 1989 & JP-A-63 244 402 ( SONY CORP. ) 11 October 1988 | 1,2,11, 15-17, 21,24, 34, 38-44, 48,51,52 | G11B5/09 G11B5/02 |
| A | * abstract * | 4,30 | |
| A | PATENT ABSTRACTS OF JAPAN vol. 11, no. 181 (P-585)11 June 1987 & JP-A-62 009 566 ( MITSUBISHI ) 17 January 1987 * abstract * | 5,9,13, 20,23, 28,32, 36,47,49 | |
| A | EP-A-0 237 682 (TOSHIBA) * abstract; figure 4 * | 24,39-42 | |
| D,A | PATENT ABSTRACTS OF JAPAN vol. 12, no. 331 (P-755)7 September 1988 & JP-A-63 094 406 ( SONY ) 25 April 1988 * abstract * | 1,16,24 | |

TECHNICAL FIELDS SEARCHED (Int. Cl.5 )

G11B

The present search report has been drawn up for all claims

| Place of search | Date of completion of the search | Examiner |
|---|---|---|
| BERLIN | 08 APRIL 1993 | DEANE I. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)